# EUROPEAN PATENT SPECIFICATION

(11) **EP 0 626 735 B1**
(45) Date of publication and mention of the grant of the patent: **13.10.1999**
(21) Application number: 94303085.8
(22) Date of filing: 28.04.1994
(51) Int. Cl.: H01M 10/48, G01R 31/36, G01R 13/40

(54) **Battery with tester label**
Batterie mit Testeretikett
Batterie pourvue d'étiquette à testeur

(30) Priority: 03.05.1993 US 56160
(43) Date of publication of application: 30.11.1994
(73) Proprietor: EVEREADY BATTERY COMPANY, INC., St. Louis Missouri 63164 (US); MORGAN ADHESIVES COMPANY, Stow Ohio 44224 (US)
(72) Inventor: Weiss, Victor H., Plantation, Florida 33322 (US); Langbehn, John G., Minnetonka, Minnesota 55305 (US); Laird, Dean A., Prior Lake Minnesota 55372 (US); Tucholski, Gary R., Parma Heights, Ohio 44130 (US); Prok, Robert A., Columbia Station, Ohio 44028 (US)
(74) Representative: Lord, Hilton David

(56) References cited:
- EP-A- 0 450 938
- EP-A- 0 495 636
- EP-A- 0 523 901
- DE-A- 3 738 731
- US-A- 5 231 356
- PATENT ABSTRACTS OF JAPAN vol. 14, no. 465 (P-1114) 9 October 1990 & JP-A-02 184 884 (TOYO SEIKAN KAISHA LTD)

## Description

The present invention relates to a tester device for a battery, the device forming an integral part of the label encasing the battery.

Batteries are generally stored for various periods of time before being put into use. The batteries may be stored in shops, for example, by the seller and frequently when purchased they are again stored by the buyer before being used. On occasion, batteries stored for a long period before being used will lose some of their charge. In view of this, therefore, it is desirable to have some means for testing the battery before use in order to determine if the battery has sufficient charge to operate the desired device.

Battery testers have been developed and are available. Initially, the testers developed were separate from the battery itself, but these testers could be used to measure the strength remaining in the battery. More recently battery testers that are either included in the battery package or assembled in the label secured to the battery have been developed. Testers of this type are generally used to indicate the capacity remaining in the battery.

U.S. Patent No. 4,702,564 discloses a device for testing a battery, particularly a small, portable battery, which device comprises a flexible, transparent substrate on which is deposited a narrow band of a black light absorbing material. A conductive material, which may taper outwardly in opposite directions from a central point to a pair of outer terminals, is then deposited on top of the substrate on the same side of the substrate as the absorber layer or on the opposite side of the substrate to the absorber layer. A layer of a cholesteric liquid crystal material is then deposited on the substrate either on the opposite side from the black absorber layer or over the absorber layer. The conductive material used in the device of this patent is an epoxy cement-based conductor, preferably silver, printed or painted directly on the substrate. An indicator scale is located along sections of the conductive material. To test a dry cell battery, the terminal ends of the conductive material are placed in contact with the battery terminals, causing a current to flow which, in turn, heats the conductive material. The heat generated is most intense at the central point and radiates outwardly. The heat is transferred through the thin substrate to the liquid crystal layer which results in a colour change in the liquid crystal. The traverse of the colour change along the length of the indicator scale, outwardly from the centre point, is proportional to the current or voltage output or the condition of the battery to be tested and can be read on the indicator scale which is calibrated accordingly. The tester also includes means for determining the amp-hours or life of a battery.

U.S. Patent No. 5,015,544 discloses a battery strength indicating and switch means on a battery. This device is coupled across the terminals of the battery and is provided with an indicating means to indicate the strength of the battery. In addition, the battery strength indicating means is provided with an in-line switch which can easily be depressed to complete the circuit so as to place the indicator means across the terminals of the cell and display the charge of the battery.

U.S. Patent No. 5,059,895 discloses a battery voltmeter comprising:
(A) a dielectric layer;
(B) a conductive layer above or below one of the surfaces of the dielectric layer; and
(C) a temperature sensitive colour indicator layer in thermal contact with the conductive layer,
characterised in that the conductive layer has (i) thermal insulating means under one of it surfaces and (ii) sufficient heat generating capacity to affect a change in the temperature sensitive colour indicator layer. The voltmeter of this patent can be integrated into a label and attached directly to a battery.

U.S. Patent No. 4,835,475 discloses an apparatus for indicating the electromotive force of a dry battery which comprises:
(i) a film base;
(ii) an electrically conductive layer disposed on one side of the film base,
(iii) a protective layer disposed on the electrically conductive layer, and
(iv) a thermochromic layer disposed on the other side of the film base.

EP-A-0 523 901 discloses a battery and integral testing device in which a single aperture in an insulating washer provides a thermally insulating air layer to enhance colour changes in a thermochromic layer supported on a conductive layer above the washer. As depicted, the size of the aperture would permit deflection of the conductive layer through the aperture.

EP-A-0 495 636 discloses a battery with tester label in which an insulative air pocket may be formed between a conductive layer and the battery housing, by the use of a suitably shaped thin solid spacer, such as of foamed plastic or adhesive.

Although testers for determining the strength remaining in a battery are available, even incorporated into the label of the battery, this art is still quite young and problems, particularly with the manufacture and expense of the devices, are encountered. Of particular significance is the fact that the prior art devices all consist of a large number of individual layers, each of which must be correctly positioned with respect to the battery itself, resulting in time-consuming manufacture and expense both to the manufacturer and to the end consumer. Furthermore, it has been found that, if the conductive layer is disposed close to the housing of the battery, which is usually a metallic material, then such housing can be used as a heat sink. If this occurs, the heat generated in the conductive layer may be insufficient to be properly detected by the thermally sensitive material and may thereby provide inaccurate information as to the strength of the battery. It has been proposed to use insulation means between the base material and the conductive layer so as to overcome this problem. However, the use of an additional layer, which will increase the overall thickness of the label, increases both the difficulties of manufacture and the cost of the article.

In view of the problems associated with the prior art, there is still a need for a testing device for a battery, which device can be assembled with the battery label and which has few components, thus making it easy to assemble, preferably by an efficient automatic assembly operation, and thereby reducing the overall cost to the manufacturer and consumer.

Accordingly, in its first aspect, the present invention provides a testing device for a battery having first and second terminals, the device comprising: a non-conductive film having two openings being so arranged that the first and second terminals of the battery are exposed therethrough; a conductive circuit layer disposed on the non-conductive film, the circuit layer covering the two openings in order to be able to contact the terminals of the battery therethrough; and a thermally sensitive material disposed in responsive contact with the conductive circuit layer such that, heat produced by the flow of current through the conductive circuit layer on contact of the conductive circuit layer with both of the terminals results in an indication by the thermally sensitive material of the charge in the battery, characterised in that a plurality of openings is arranged in the non-conductive film between the two openings so as to provide thermal insulation for the conductive circuit layer and in that the plurality of openings has an opening size such as to prevent deflection of the conductive circuit layer through the plurality of openings onto the battery housing.

In a preferred embodiment of this aspect of the invention, the testing device forms all, or part, of the label for the battery.

In a further preferred embodiment, the conductive circuit layer and the plurality of openings in the non-conductive film are so arranged that the conductive circuit layer is unable significantly to contact the battery through the plurality of openings in the non-conductive film.

In a specific embodiment of this aspect of the invention, there is provided a battery having a first terminal and a second terminal of opposite polarity; said battery at least partially encased with a non-conductive film having a top surface and bottom surface and said film defining a first opening exposing a segment of the first terminal and a spaced apart second opening exposing a segment of the second terminal, and a conductive circuit layer disposed over the first opening and the second opening so that a first segment of conductive circuit layer can be deflected through the first opening to contact the first terminal and a second segment of the conductive circuit layer can be deflected through the second opening to contact the second terminal; a thermally sensitive material disposed in responsive contact with the conductive circuit layer such that when the first segment and second segment of the conductive circuit layer contact the first terminal and second terminal, respectively, a current will flow through the conductive circuit layer and heat the thermally sensitive material which will indicate the capacity of the battery, characterised in that a plurality of openings is arranged in the non-conductive film between the two openings so as to provide thermal insulation for the conductive circuit layer, and in that the plurality of openings has an opening size such as to prevent deflection of the conductive circuit layer through the plurality of openings onto the battery housing.

In an alternative aspect, the present invention provides a battery including a testing device as defined above.

### Brief Description of the Drawings

The invention will now be further described with reference to the following drawings, in which:

Figure 1 is an exploded view of the various components of test circuit labels of this invention.

Figure 2 is a plan view of a continuous sheet of label carrier containing the individual test circuit devices of this invention.

Figure 3 is an isometric view of a cell employing the test circuit device of this invention.

Figure 4 is an isometric view of a cell employing the test circuit device of this invention encased in an outer layer.

The non-conductive, base, film of the tester of this invention includes numerous openings therein, two of which openings must, in use, expose the first and second terminals of the battery. The precise number of openings is not essential to the present invention and depends, for example, on the size of the battery for which the tester is destined.

The non-conductive base film comprises two openings, one of which must, in use, be disposed over the first terminal and the other of which must, in use, be disposed over the second terminal of the battery. The precise size of these two openings is not essential to the present invention and depends on, for example, the type of battery for which the tester is destined. In particular, the openings should be of a size sufficient to allow contact between the conductive circuit layer covering said openings and the terminal of the battery. Typically, however, we have found that openings of from 0.001 square inch to 0.008 square inch (6.45 x 10⁵ µm² to 51.61 x 10⁵ µm²), preferably from 0.003 to 0.005 square inch (19.35 x 10⁵ to 32.26 x 10⁵ µm²) are suitable. Within this range, the smaller openings would be most suitable for smaller batteries, such as the AAA type cells, whereas openings towards the top end of the range would be most suitable for batteries with a larger diameter and different curvature, for example the D-size batteries.

The precise size of the remaining, plurality of, openings in the non-conductive base film is likewise not essential to the present invention, although these openings should be of such a size to prevent deflection of the conductive circuit layer through the openings onto the battery housing. It is preferred that these openings are smaller than those arranged to be disposed over the terminals of the cell. Typically, these remaining openings can vary in size from 0.0001 square inch to 0.004 square inch (6.45 x 10⁴ to 25.8 x 10⁵ µm²) and preferably from 0.0004 square inch to 0.002 square inch (25.8 x 10⁴ to 12.9 x 10⁵ µm²). Within this range, openings at the lower end of the range would be most appropriate for the smaller AAA size cells, whilst for the D size cells, openings of a size towards the higher end of the range would be more appropriate.

Thus, for example, AAA size cells could have the two openings disposed over the terminals of the battery of a size with in the range of 0.001 to 0.003 square inch (64.52 x 10⁴ to 19.35 x 10⁵ µm²), whereas the remaining openings could be within the range of from 0.0001 to 0.0003 square inch (64.52 x 10³ to 19.35 x 10⁴ µm²). For an AA size cell the first and second openings could be of a size within the range 0.002 to 0.004 square inch (12.9 x 10⁵ to 25.8 x 10⁵ µm²), whilst the remaining openings could have a size within the range of from 0.0003 to 0.001 square inch (19.35 x 10³ to 64.52 x 10⁴ µm²). For D size cells the first and second opening could be of from 0.003 to 0.008 square inch (19.35 x 10⁴ to 51.62 x 10⁵ µm²), whilst the remaining openings could be of from 0.001 to 0.003 square inch (64.52 x 10⁴ to 19.35 x 10⁵ µm²).

In one preferred embodiment, one of the two openings disposed over the terminals of the battery is in the form of a slot or groove leading directly onto the edge of the non-conductive base film, the only proviso being that the conductive circuit must still be capable of deflection to contact the cover of the cell. In this embodiment, therefore, the size of either of the two terminal openings could exceed 0.01 square inch (64.52 x 10³ µm²). In a more preferred embodiment, it is the opening covering the second terminal which is in the form of a slit or groove.

In general, the precise shape of the openings, that is the two openings disposed over the terminals of the battery and the remaining openings therebetween, is not essential to the present invention. However, it is apparent from the above description that the openings disposed over the terminals of the battery must be of such a shape as to allow deflection of the covering conductive circuit material such that this can contact the terminal. The openings disposed between those at the two terminals of the battery may be circular, elliptical, square, rectangular or of any other polygonal shape.

The non-conductive film of the tester of the present invention may be made of any desired dielectric polymeric material, although it is preferred to use a dielectric polymeric material that will shrink when assembled on a battery. Examples of suitable polymeric materials include polyvinyl resins, polyolefin resins and polyester resins, specific examples of which include polyvinyl chloride, polyethylene and polypropylene. The precise thickness of the non-conductive film is not particularly limited and we have found that a thickness of from about 0.0005 to 0.005 inch (12.7 to 127 µm), preferably 0.001 to 0.003 inch (25.4 to 76.2 µm), is particularly suitable.

The conductive circuit layer may be formed from any material which can conduct an electrical charge. Typically, this layer may be formed from a metallic foil such as silver, nickel, iron, copper, lead, etc., and mixtures thereof or a metallized plastic layer. In the alternative, the layer may be formed from an electrically conductive polymer, or mixtures of such polymers, paints or inks, such as those that contain graphite, carbon or metals such as silver or combinations thereof which could be applied onto a substrate as the conductive layer. It is preferred that this layer is formed from silver.

The device of the present invention also includes means for indicating the capacity of the battery. The indicating means, m the form of a thermally sensitive layer, are in responsive contact with the area of controlled resistivity and will respond to and indicate the capacity of the battery. For example, a temperature will be generated in that area when a current flows through the conductive circuit layer. Thermally sensitive material will be in thermally transferable contact with the area of controlled resistivity and will indicate to the consumer the capacity of the battery. This indication can be qualitative such as a "good" reading, or quantitative such as a remaining percentage of useful life. The thermally sensitive materials would be readily viewable by a consumer. Thus the consumer, based on, for example, the colour change, can determine whether the battery is good or needs to be replaced.

Examples of suitable thermally sensitive materials include liquid crystal materials and thermochromic inks. Suitable liquid crystal materials are of the cholesteric type, such as cholesteryl oleate, cholesteryl chloride, cholesteryl caprylate and the like. Examples of suitable colour thermochromic inks include those comprised of a dye, developer and desensitizing agent, for example as disclosed in U.S. Patent No. 4,835,475. The colour indicator material could change from coloured to colourless, colourless to coloured, or one colour to a second colour.

The indicating materials, such as thermochromic inks, may be used singly or in combination. For example, in one embodiment different layers of the indicating material may be employed. The layers would be activated at different temperatures or states and can thus be designed to change to different colours at different temperatures. For example, the layer of material activated at the highest temperature will preferably be the bottom layer, and the upper layers would then suitably be arranged according to the temperature of activation such that the material with the lowest temperature of activation would form or comprise the top layer.

In the device of the present invention the conductive circuit layer may be deflected through the opening in the non-conductive layer disposed over one of both of the terminals such that a circuit is completed. However, in a preferred embodiment of the tester device of the present invention, in use, at one of the terminals the conductive circuit layer is arranged so as to be in permanent contact with the terminal, so that, in order to complete the circuit it is necessary only to deflect the conductive circuit layer through the opening in the non-conductive film at the other terminal. In one embodiment of the invention either the anode or cathode is in electrical contact with the conductive housing of the battery. In this embodiment, one of the terminal contact segments ends of the tester circuit can be permanently connected to one terminal of the housing while the other contact end is positioned out of contact with the other terminal of the housing by an opening in the base layer disposed between the housing and the segment end of the tester circuit. This opening can act as a switch for the tester circuit. By forcing the circuit contact segment end into contact with the housing through the opening, the switch is closed and the tester circuit is completed to test the battery. This contact can be conveniently made by applying finger or thumb pressure to the switch areas.

As discussed above, the testing device of this invention is suited for use as, or forming part of, the label for a battery. In such case, the label may also comprise additional insulative layers, printing layers, protective layers and the like. Suitable materials for use as the different layers are those typically used in battery labels and include plasticised or unplasticised polyvinyl chloride (UPVC), polyesters, metallic films, paper and like, and they are prepared by known methods, such as laminating the layers together. The label may be attached to the battery by the use of an adhesive. The tester label may be in the form of a single ply label or a shrinkable tube label in which a battery is encased.

A preferred tester label may include components as described in the following. A base insulative film may be adhered to the housing of the battery, which is in electrical contact with either the anode or cathode of the battery, by a suitable adhesive. The insulative film has two openings in it, as described above, for contact with the cell terminals. A separate tester circuit assembly is suitably placed on the top surface of this insulative film and one of the terminal contact segment ends of the circuit will then be aligned with one of the openings in the base film. The other terminal contact segment end of the circuit should then be aligned with the second opening such that it is in contact with and secured to the terminal of the battery (generally the cover) that is not in contact with the housing. The area of the base film onto which the tester circuit is placed has a plurality of openings as described above to function as thermal insulation means for said tester circuit. The thermal indicating material is then suitably placed over the area of controlled resistivity of the circuit. The indicating material may be placed directly on the tester circuit or it may be placed on a separate layer that is placed over the tester circuit. Preferably, the indicating material is a thermochromic ink and is in thermally transferable contract with the area of controlled resistivity. Finally a protective layer may be placed over the indicating material. The type of protective layer is selected so that the indicating material can be observed by the user. To test the strength of the battery, the user will press the label at the point above one or both openings in the insulator film to establish contact with the terminals of the battery housing. As the circuit is completed, a temperature increase will be generated in the area of controlled resistivity which will be transferred to the indicating material. If the desired temperature level is reached, the indicating material will so indicate and the user can determine the amount of capacity remaining in the battery.

In one embodiment of the invention, an outer film may be disposed over the base film containing the battery tester device and said base material and/or the outer film can contain printed and graphic design matter for the battery. A suitable material for the outer film includes polyester, polyvinyl chloride or the like.

The batteries useful in this invention are primary or secondary batteries that have positive and negative terminals. The batteries generally comprise an anode, a cathode and electrolyte contained in a sealed housing. The housing typically has an opening in one end that is sealed and closed with a cover. This cover is usually in electrical contact with either the cathode or anode to provide a terminal of the battery while the terminal of opposite polarity, generally the battery housing, is usually in electrical contact with the other electrode.

The test device label of this invention in addition to providing a label for the battery, provides a test device that is integral with the label and thereafter becomes an integral part of the battery. The test device operates such that by depressing one or two selected areas of the conductive circuit layer, the circuit is completed between the terminals of the battery via the conductive circuit layer which in turn generates heat. The heat generated is detected by the thermally sensitive material to provide a visual indication of the strength of the battery.

One particular advantage of the device of the present invention is the incorporation into the non-conductive base film of a plurality of a small openings. These openings act as a thermal insulation for the conductive layer. Thus the segment of the base film will function as a thermal and electrical insulator for the conductive circuit layer. In this arrangement, a minimum number of parts are required to produce a battery label having an integral battery tester for checking whether the battery is charged.

A preferred method for attachment of the test circuit label on the battery is in a continuous operation and involves, for example, first the preparation of a base film, such as a plastic film made with graphics and printed matter on the top side along with a first opening, second opening and plurality of openings as discussed above. An adhesive may then be added to the bottom side of this film, which may then be attached to a suitable releasable material, such as silicone-coated release paper, to form a label carrier. In a separate operation, a circuit tester layer of the desired shape and format may then be deposited on a substrate along with a thermally sensitive material, such as thermochromic ink. An adhesive is then suitably added to the bottom surface of the substrate leaving the appropriate test circuit segment ends free of the adhesive. The side of the substrate to which the adhesive has been applied is then typically attached to releasable paper, such as silicone-coated paper, and then wound on a roll.

The resulting tester circuit roll containing the individual circuit tester devices may then be placed in a dispensing machine so as to feed the test circuit devices onto the base layer, the preparation of which is described above, in a fixed time sequence. Means can be included on the machine to detect when the area of the label containing the openings reaches a specific location, at which stage a test circuit device cut to a desired size may be dispensed without the releasable paper web and positioned over and secured to the selected area of the base label.

If desired, additional graphics could be printed on the base label and/or the test circuit layer before an outer layer is secured to the base layer. The completed base layer is cut to a desired size and then fed to another area where the silicone-coated paper web is removed and the label is secured to the housing of the battery. If desired, graphics could be placed on the outer layer of the label.

In an alternative method, the conductive material may be hot stamped onto the substrate. We prefer that the conductive circuit layer is formed as a separate part, preferably on a substrate, and shaped to have first and second segment ends that are connected to each other via an area of controlled resistivity. The first segment is suitably provided to contact a first terminal of the battery and the second segment is likewise provided to make contact with the second terminal of the battery. Thus, when the conductive circuit layer makes contact with both terminals of the battery, an electric current will flow through the area of controlled resistivity which will heat the conductive circuit layer to a range sufficient to activate the thermally sensitive material. The resistance in the area of controlled resistivity can vary to it can be constant dependent on the particular application of use.

The invention will now be further described with reference to the drawings appended hereto.

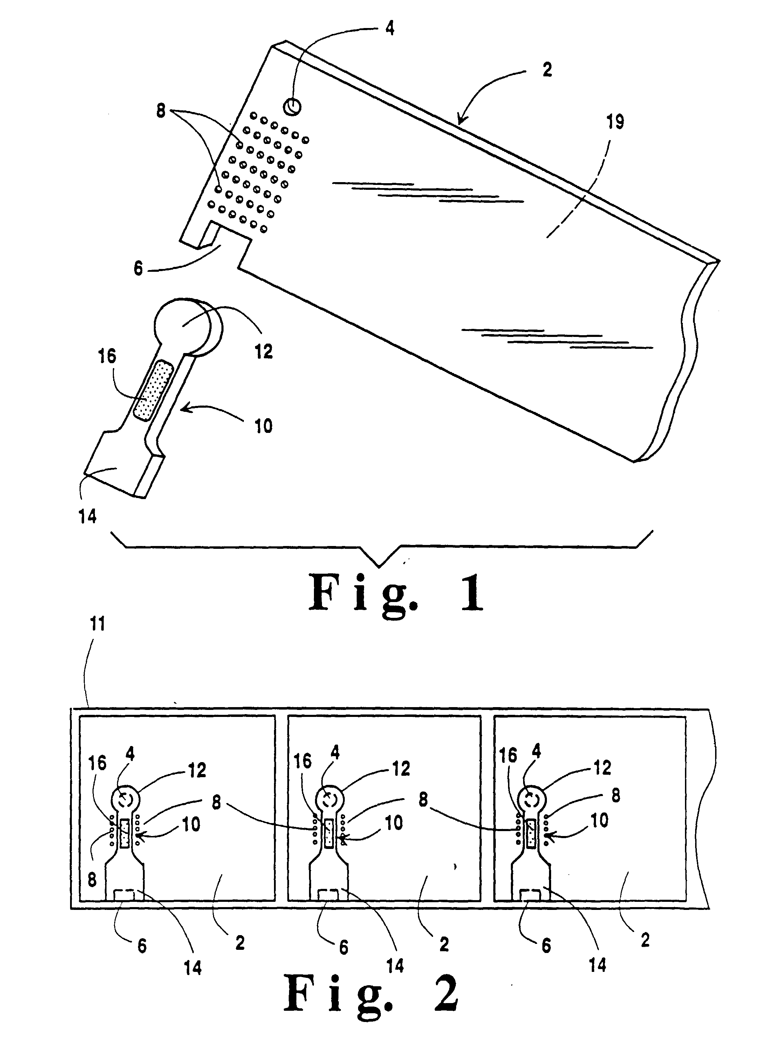

Referring to Figure 1 there is shown a base film 2 such as PVC, which has a first opening 4, a second opening 6 in the form of a slot and disposed between opening 4 and opening 6 is a plurality of small openings 8. A conductive layer 10 is selectively shaped so that it can be placed over opening 4, opening 6 and at least some of the plurality of openings 8. Opening 4 is sufficiently large so that conductive segment layer 12 can be depressed into and through opening 4. Opening 6 is in the form of a notch so that conductive segment layer 14 can be depressed into and through notch 6 to contact a terminal of the cell. On top of conductive layer 10 is a thermally sensitive material 16 such as a thermochromic material, which will change color upon detection of a particular temperature level.

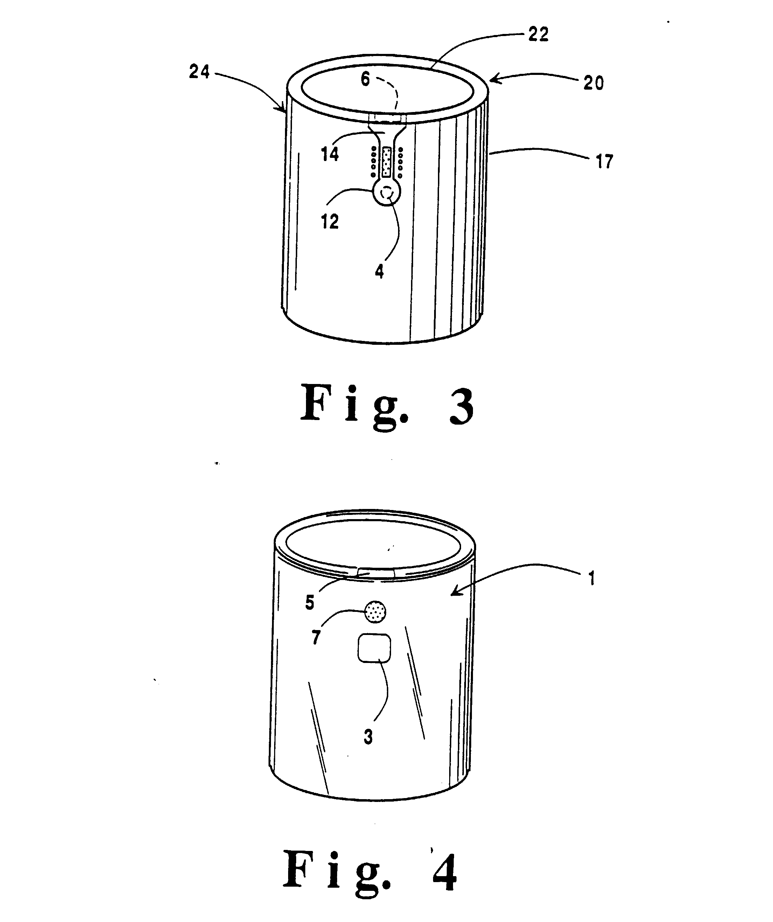

As shown in Fig. 2, a plurality of conductive layer devices 10 is shown secured on base film 2 releasably secured on a carrier layer 11, such as a silicone-coated paper, and disposed over opening 4, opening 6 and plurality of openings 8. Disposed on top of conductive layer 10 is thermally sensitive material 16. If desired, a non-conductive film or coating (not shown) could be disposed over base film 2 thereby further securing conductive layer 10 and thermally sensitive material to base film 2. This top layer could have an adhesive side to secure to the base film 2. This non-conductive film could be in the form of a tube that could be heat shrunk onto the cell after the label is applied to the cell. Base film 2 has an adhesive layer 19 on its bottom surface (see Figure 1) which is secured to a battery as shown in Figure 3.

Specifically, Figure 3 shows a battery test label 17 on base film 2 (not shown) secured to the housing of battery 20. Conductive segment layer 14 is in electrical contact with cover 22 which represents one terminal of battery 20. This conductive segment layer 14 can be permanently connected to conductive cover 22. The conductive segment layer 12 is disposed over opening 4 and is spaced apart from the cylindrical housing 24 of the battery 20 which is the second terminal of the battery 20. Thus the circuit between the two terminals of battery 20 via conductive segment layers 12 and 14 is open. To close the circuit, pressure is applied on the flexible upper layer above opening 4 in the base film. The pressure will cause the conductive segment layer 12 to make electrical contact with the battery housing 24 through opening 4. Rigidity and springback in the label will cause conductive segment layer 12 to break contact with housing 24 when the pressure is released. If desired, conductive segment layer 14 can also be spaced apart from the cover 22 so that to complete the circuit, pressure will have to be simultaneously applied to the flexible upper layer above both openings 4 and 6 in the base film. When the pressure is released, conductive layer segments 12 and 14 will spring back and break contact with the housing 24 and cover 22, respectively. As stated above, suitable graphics and printed matter can be placed on the base layer, conductive layer, thermally sensitive material and/or the outer layer.

As shown in Figure 4, an outer layer 1 contains designated areas 3 and 5 which correspond to the first terminal area and second terminal area, respectively, of the cell. Designated area 7 exposes an area of the thermally sensitive material so that when areas 3 and 5 are depressed, a circuit is completed and the thermally sensitive material will change colour to indicate the state of charge of the cell. If desired, either area 5 or 3 could be permanently secured to a terminal so that only area 3 or 5, respectively, would have to be depressed to complete the circuit.

This invention has been described in detail with particular reference to preferred embodiments thereof, but it will be understood that variations and modifications can be effected. For example, an adhesive strip could be secured over the conductive circuit layer containing the thermally sensitive material so that the conductive circuit layer could be secured to the base film using the adhesive strip.

## Claims

1. A testing device for a battery having first and second terminals, the device comprising: a non-conductive film (2) having two openings (4, 6) being so arranged that the first and second terminals of the battery are exposed therethrough; a conductive circuit layer (10) disposed on the non-conductive film (2), the circuit layer (10) covering the two openings (4, 6) in order to be able to contact the terminals of the battery therethrough; and a thermally sensitive material (16) disposed in responsive contact with the conductive circuit layer (10) such that, heat produced by the flow of current through the conductive circuit layer (10) on contact of the conductive circuit layer (10) with both of the terminals results in an indication by the thermally sensitive material (16) of the charge in the battery, characterised in that a plurality of openings (8) is arranged in the non-conductive film (2) between the two openings (4, 6) so as to provide thermal insulation for the conductive circuit layer (10) and in that the plurality of openings (8) has an opening size such as to prevent deflection of the conductive circuit layer (10) through the plurality of openings (8) onto the battery housing.

2. A device according to Claim 1 in which the conductive circuit layer (10) and the plurality of openings (8) in the non-conductive film (12) are so arranged that the conductive circuit layer (10) is unable significantly to contact the battery through the plurality of openings (8) in the non-conductive film (2).

3. A device according to Claim 1 or Claim 2, in which the plurality of openings (8) are from 0.0001 to 0.004 square inch (6.45 x 10⁴ to 25.8 x 10⁵ µm²) in size.

4. A device according to Claim 3, in which the plurality of openings (8) are from 0.0004 to 0.002 square inch (25.8 x 10⁴ to 12.9 x 10⁵ µm²) in size.

5. A device according to any one of Claims 1 to 4, in which the non-conductive film (2) is formed from a dielectric polymeric material, particularly a polyvinyl resin, polyolefin resin or polyester resin.

6. A device according to Claim 5, in which the non-conductive film (2) is from 0.0005 to 0.05 inches (12.7 to 127 µm), preferably 0.001 to 0.003 (25.4 to 76.2 µm) thick.

7. A device according to any one of Claims 1 to 6, in which the conductive circuit layer (10) is formed from a metallic foil or mixtures thereof, a metallised plastic layer, an electrically conductive polymer, or mixtures thereof, paint or ink, carbon or a metal.

8. A device according to Claim 7, in which the conductive circuit layer (10) is formed from silver, nickel, iron, copper, carbon, lead, conductive paint, conductive polymers, conductive ink or mixtures thereof.

9. A device according to Claim 8, in which the conductive circuit layer (10) is formed from silver.

10. A device according to any preceding Claim, in which the thermally sensitive material (16) is a thermochromic ink or a liquid crystal material.

11. A device according to Claim 10, in which the thermally sensitive material (16) is a thermochromic ink.

12. A device according to any preceding Claim, in which, in use, the conductive circuit layer (10) is so arranged at one of the terminals to be in permanent contact with that terminal.

13. A battery having a first terminal and a second terminal of opposite polarity; said battery at least partially encased with a non-conductive film (2) having a top surface and bottom surface and said film defining a first opening (4) exposing a segment of the first terminal and a spaced apart second opening (6) exposing a segment of the second terminal, and a conductive circuit layer (10) disposed over the first opening (4) and the second opening (6) so that a first segment (12) of conductive circuit layer (10) can be deflected through the first opening (4) to contact the first terminal and a second segment (14) of the conductive circuit layer(10) can be deflected through the second opening (6) to contact the second terminal; a thermally sensitive material (16) disposed in responsive contact with the conductive circuit layer (10) such that when the first segment (12) and second segment (14) of the conductive circuit layer (10) contact the first terminal and second terminal, respectively, a current will flow through the conductive circuit layer (10) and heat the thermally sensitive material (16) which will indicate the capacity of the battery, characterised in that a plurality of openings (8) is arranged in the non-conductive film (2) between the two openings (4, 6) so as to provide thermal insulation for the conductive circuit layer (10), and in that the plurality of openings (8) has an opening size such as to prevent deflection of the conductive circuit layer (10) through the plurality of openings (8) onto the battery housing.

14. A battery including a testing device according to any one of the preceding Claims 1 to 12.

15. A battery according to Claim 14, in which the device forms all or part of the label.

16. A battery according to Claim 15 further including a film heat shrunk over at least the testing device.

17. A battery according to any one of Claims 13 to 16 comprising a housing (24) composed of a cylindrical container closed at one end and open at the opposite end, said container forming the first terminal of the battery; and a cover (22) secured over and electrically insulated from the open end of the container, said cover forming the second terminal of the battery.

## Patentansprüche

1. Testvorrichtung für eine Batterie mit einem ersten und einem zweiten Anschluß, wobei die Testvorrichtung aufweist: eine nichtleitende Folie (2) mit zwei Öffnungen (4, 6), die so angeordnet sind, daß der erste und der zweite Anschluß der Batterie durch die Öffnungen freigelegt werden; eine auf der nichtleitenden Folie (2) angeordnete leitende Stromkreisschicht (10), wobei die Stromkreisschicht (10) die beiden Öffnungen (4, 6) bedeckt, um durch die Öffnungen mit den Anschlüssen der Batterie in Kontakt kommen zu können; und ein wärmeempfindliches Material (16), das in reaktionsfähigem Kontakt mit der leitenden Stromkreisschicht (10) angeordnet ist, so daß Wärme, die durch den Stromfluß durch die leitende Stromkreisschicht (10) entwickelt wird, beim Kontakt der leitenden Stromkreisschicht (10) mit den beiden Anschlüssen eine Anzeige der in der Batterie enthaltenen Ladung durch das wärmeempfindliche Material (16) hervorruft, dadurch gekennzeichnet, daß zwischen den beiden Öffnungen (4, 6) mehrere Öffnungen (8) in der nichtleitenden Folie (2) angeordnet sind, um für eine Wärmeisolierung der leitenden Stromkreisschicht (10) zu sorgen, und daß die Größe der mehreren Öffnungen (8) so gewählt ist, daß eine Durchbiegung der leitenden Stromkreisschicht (10) durch die mehreren Öffnungen (8) hindurch auf das Batteriegehäuse verhindert wird.

2. Vorrichtung nach Anspruch 1, wobei die leitende Stromkreisschicht (10) und die mehreren Öffnungen (8) in der nichtleitenden Folie (2) so angeordnet sind, daß die leitende Stromkreisschicht (10) durch die mehreren Öffnungen (8) in der nichtleitenden Folie (2) im wesentlichen nicht mit der Batterie in Kontakt kommen kann.

3. Vorrichtung nach Anspruch 1 oder Anspruch 2, wobei die mehreren Öffnungen (8) eine Größe von 0,0001 bis 0,004 Quadratzoll (6,45 x 10⁴ bis 25,8 x 10⁵ µm²) haben.

4. Vorrichtung nach Anspruch 3, wobei die mehreren Öffnungen (8) eine Größe von 0,0004 bis 0,002 Quadratzoll (25,8 x 10⁴ bis 12,9 x 10⁵ µm²) haben.

5. Vorrichtung nach einem der Ansprüche 1 bis 4, wobei die nichtleitende Folie (2) aus einem dielektrischen Polymermaterial gebildet wird, insbesondere aus einem Polyvinylharz, Polyolefinharz oder Polyesterharz.

6. Vorrichtung nach Anspruch 5, wobei die nichtleitende Folie (2) 0,0005 bis 0,05 Zoll (12,7 bis 127 µm), vorzugsweise 0,001 bis 0,003 Zoll (25,4 bis 76,2 µm) dick ist.

7. Vorrichtung nach einem der Ansprüche 1 bis 6, wobei die leitende Stromkreisschicht (10) aus einer Metallfolie oder Gemischen daraus, einer metallisierten Kunststoffschicht, einem elektrisch leitenden Polymer oder Gemischen daraus, Farbe oder Druckfarbe, Kohlenstoff oder einem Metall gebildet wird.

8. Vorrichtung nach Anspruch 7, wobei die leitende Stromkreisschicht (10) aus Silber, Nickel, Eisen, Kupfer, Kohlenstoff, Blei, leitfähiger Farbe, leitfähigen Polymeren, leitfähiger Druckfarbe oder Gemischen daraus besteht.

9. Vorrichtung nach Anspruch 8, wobei die leitende Stromkreisschicht (10) aus Silber besteht.

10. Vorrichtung nach einem der vorstehenden Ansprüche, wobei das wärmeempfindliche Material (16) eine thermochrome Druckfarbe oder ein Flüssigkristallmaterial ist.

11. Vorrichtung nach Anspruch 10, wobei das wärmeempfindliche Material (16) eine thermochrome Druckfarbe ist.

12. Vorrichtung nach einem der vorstehenden Ansprüche, wobei im Gebrauch die leitende Stromkreisschicht (10) an einem der Anschlüsse so angeordnet ist, daß sie sich in permanentem Kontakt mit diesem Anschluß befindet.

13. Batterie die aufweist: einen ersten Anschluß und einen zweiten Anschluß von entgegengesetzter Polarität; wobei die Batterie zumindest teilweise in eine nichtleitende Folie (2) mit einer oberen Fläche und einer unteren Fläche eingehüllt ist und die Folie eine erste Öffnung (4), die einen Abschnitt des ersten Anschlusses freilegt, und eine davon beabstandete zweite Öffnung (6) bildet, die einen Abschnitt des zweiten Anschlusses freilegt, und eine leitende Stromkreisschicht (10), die über der ersten Öffnung (4) und der zweiten Öffnung (6) so angeordnet ist, daß ein erster Abschnitt (12) der leitenden Stromkreisschicht (10) durch die erste Öffnung (4) durchgebogen werden kann, um mit dem ersten Anschluß in Kontakt zu kommen, und daß ein zweiter Abschnitt (14) der leitenden Stromkreisschicht (10) durch die zweite Öffnung (6) durchgebogen werden kann, um mit dem zweiten Anschluß in Kontakt zu kommen; ein wärmeempfindliches Material (16), das in reaktionsfähigem Kontakt mit der leitenden Stromkreisschicht (10) angeordnet ist, so daß, wenn der erste Abschnitt (12) bzw. der zweite Abschnitt (14) der leitenden Stromkreisschicht (10) mit dem ersten Anschluß bzw. dem zweiten Anschluß in Kontakt kommen, ein Strom durch die leitende Stromkreisschicht (10) fließt und das wärmeempfindliche Material (16) erwärmt, das die Kapazität der Batterie anzeigt, dadurch gekennzeichnet, daß in der nichtleitenden Folie (2) zwischen den beiden Öffnungen (4, 6) mehrere Öffnungen (8) angeordnet sind, um für eine Wärmeisolierung der leitenden Stromkreisschicht (10) zu sorgen, und daß die Größe der mehreren Öffnungen (8) so gewählt ist, daß eine Durchbiegung der leitenden Stromkreisschicht (10) durch die mehreren Öffnungen (8) auf das Batteriegehäuse verhindert wird.

14. Batterie mit einer Testvorrichtung nach einem der vorstehenden Ansprüche 1 bis 12.

15. Batterie nach Anspruch 14, wobei die Vorrichtung das gesamte Etikett oder einen Teil davon bildet.

16. Batterie nach Anspruch 15, die ferner eine Folie aufweist, die mittels Wärme zumindest auf die Testvorrichtung aufgeschrumpft ist.

17. Batterie nach einem der Ansprüche 13 bis 16 mit einem Gehäuse (24), das aus einem an einem Ende geschlossenen und am gegenüberliegenden Ende offenen zylindrischem Behälter besteht, wobei der Behälter den ersten Anschluß der Batterie bildet; und mit einem Deckel (22), der über dem offenen Ende des Behälters befestigt und dagegen elektrisch isoliert ist, wobei der Deckel den zweiten Anschluß der Batterie bildet.

## Revendications

1. Dispositif de test pour une pile comportant des première et seconde bornes, le dispositif comprenant: un film non conducteur (2) comportant deux ouvertures (4, 6) qui sont agencées de telle sorte que les première et seconde bornes de la pile soient exposées au travers; une couche de circuit conductrice (10) disposée sur le film non conducteur (2), la couche de circuit (10) recouvrant les deux ouvertures (4, 6) de manière à pouvoir entrer en contact avec les bornes de la pile au travers; et un matériau thermosensible (16) disposé de manière à être en contact de réponse avec la couche de circuit conductrice (10) de telle sorte que de la chaleur produite par la circulation de courant au travers de la couche de circuit conductrice (10) lors du contact de la couche de circuit conductrice (10) avec les deux bornes conduise à une indication par le matériau thermosensible (16) de la charge dans la pile, caractérisé en ce que des ouvertures (8) selon une pluralité sont agencées dans le film non conducteur (2) entre les deux ouvertures (4, 6) de manière à constituer une isolation thermique pour la couche de circuit conductrice (10) et en ce que les ouvertures de la pluralité d'ouvertures (8) présentent une dimension d'ouverture qui est telle qu'elle permet d'empêcher une flexion de la couche de circuit conductrice (10) au travers de la pluralité d'ouvertures (8) sur le boîtier de pile.

2. Dispositif selon la revendication 1, dans lequel la couche de circuit conductrice (10) et les ouvertures de la pluralité d'ouvertures (8) dans le film non conducteur (2) sont agencées de telle sorte que la couche de circuit conductrice (10) ne puisse pas entrer de façon significative en contact avec la pile au travers de la pluralité d'ouvertures (8) dans le film non conducteur (2).

3. Dispositif selon la revendication 1 ou 2, dans lequel les ouvertures de la pluralité d'ouvertures (8) sont d'une dimension comprise entre 0,0001 et 0,004 pouce carré (de 6,45 x 10⁴ à 25,8 x 10⁵ µm²).

4. Dispositif selon la revendication 3, dans lequel les ouvertures de la pluralité d'ouvertures (8) sont d'une dimension comprise entre 0,0004 et 0,002 pouce carré (de 25,8 x 10⁴ à 12,9 x 10⁵ µm²).

5. Dispositif selon l'une quelconque des revendications 1 à 4, dans lequel le film non conducteur (2) est formé à partir d'un matériau polymérique diélectrique, plus particulièrement d'une résine polyvinyle, d'une résine polyoléfine ou d'une résine polyester.

6. Dispositif selon la revendication 5, dans lequel le film non conducteur (2) est d'une épaisseur comprise entre 0,0005 et 0,05 pouce (de 12,7 à 127 µm), de préférence entre 0,001 et 0,003 pouce (de 25,4 à 76,2 µm).

7. Dispositif selon l'une quelconque des revendications 1 à 6, dans lequel la couche de circuit conductrice (10) est formée à partir d'une feuille métallique ou de mélanges afférents, d'une couche de plastique métallisée, d'un polymère électriquement conducteur ou de mélanges afférents, de peinture ou d'encre, de carbone ou de métal.

8. Dispositif selon la revendication 7, dans lequel la couche de circuit conductrice (10) est formée à partir d'argent, de nickel, de fer, de cuivre, de carbone, de plomb, de peinture conductrice, de polymères conducteurs, d'encre conductrice ou de mélanges afférents.

9. Dispositif selon la revendication 8, dans lequel la couche de circuit conductrice (10) est formée à partir d'argent.

10. Dispositif selon l'une quelconque des revendications précédentes, dans lequel le matériau thermosensible (16) est une encre thermochromique ou un matériau de cristaux liquides.

11. Dispositif selon la revendication 10, dans lequel le matériau thermosensible (16) est une encre thermochromique.

12. Dispositif selon l'une quelconque des revendications précédentes, dans lequel, en utilisation, la couche de circuit conductrice (10) est agencée au niveau de l'une des bornes de manière à être en contact permanent avec cette borne.

13. Pile comportant une première borne et une seconde borne de polarités opposées; ladite pile qui est au moins partiellement enchâssée à l'aide d'un film non conducteur (2) comportant une surface supérieure et une surface inférieure et ledit film définissant une première ouverture (4) qui expose un segment de la première borne et une seconde ouverte (6) espacée de la première ouverture qui expose un segment de la seconde borne, et une couche de circuit conductrice (10) disposée au-dessus de la première ouverture (4) et de la seconde ouverture (6) de telle sorte qu'un premier segment (12) de la couche de circuit conductrice (10) puisse être fléchi au travers de la première ouverture (4) pour entrer en contact avec la première borne et qu'un second segment (14) de la couche de circuit conductrice (10) puisse être fléchi au travers de la seconde ouverture (6) pour entrer en contact avec la seconde borne; un matériau thermosensible (16) disposé en contact de réponse avec la couche de circuit conductrice (10) de telle sorte que lorsque le premier segment (12) et le second segment (14) de la couche de circuit conductrice (10) entrent respectivement en contact avec la première borne et la seconde borne, un courant circule au travers de la couche de circuit conductrice (10) et chauffe le matériau thermosensible (16) qui indique alors la capacité de la pile, caractérisée en ce que des ouvertures (8) selon une pluralité sont agencées dans le film non conducteur (2) entre les deux ouvertures (4, 6) de manière à constituer une isolation thermique pour la couche de circuit conductrice (10) et en ce que les ouvertures de la pluralité d'ouvertures (8) présentent une dimension d'ouverture qui est telle qu'elle permet d'empêcher une flexion de la couche de circuit conductrice (10) au travers de la pluralité d'ouvertures (8) sur le boîtier de pile.

14. Pile incluant un dispositif de test selon l'une quelconque des revendications précédentes 1 à 12.

15. Pile selon la revendication 14, dans laquelle le dispositif forme la totalité ou une partie d'une étiquette.

16. Pile selon la revendication 15, incluant en outre un film appliqué par retrait thermique au-dessus d'au moins le dispositif de test.

17. Pile selon l'une quelconque des revendications 13 à 16, comprenant un boîtier (24) constitué par un conteneur cylindrique fermé au niveau d'une extrémité et ouvert au niveau de l'extrémité opposée, ledit conteneur formant la première borne de la pile; et un couvercle (22) fixé au-dessus de l'extrémité ouverte du conteneur et isolé électriquement de celle-ci, ledit couvercle formant la seconde borne de la pile.
